# EUROPÄISCHE PATENTANMELDUNG

(11) **EP 3 758 232 A1**
(43) Veröffentlichungstag der Anmeldung: **30.12.2020**
(21) Anmeldenummer: 20177021.1
(22) Anmeldetag: 28.05.2020
(51) Int. Cl.: H03K 17/955

(54) **SENSOREINRICHTUNG, INSBESONDERE ZUR ERFASSUNG VON OBJEKTEN**

(30) Priorität: 28.06.2019 DE 102019209433
(71) Anmelder: Robert Bosch GmbH, 70442 Stuttgart (DE)
(72) Erfinder: Bonemberg, Adam, 70195 Stuttgart (DE); Fischer, Chris, 70435 Stuttgart (DE); Iske, Burkhard, 71272 Renningen (DE)

(57) **Zusammenfassung**

Eine Sensoranordnung (10) zum Erfassen von Objekten (50) mit einer ersten kapazitiven Sensoreinrichtung (2), welche eine erste Elektrode (22) sowie eine zweite Elektrode (24) aufweist, zwischen denen ein erstes elektrisches Feld (E1) aufbaubar ist und mit einer zweiten kapazitiven Sensoreinrichtung (4), welche eine erste Elektrode (42) sowie eine zweite Elektrode (44) aufweist, zwischen denen ein zweites elektrisches Feld (E2) aufbaubar ist, dadurch gekennzeichnet, dass
die Sensoranordnung (10) eine dritte kapazitive Sensoreinrichtung (6) aufweist, welche eine erste Elektrode (62) und eine zweite Elektrode (64) aufweist, zwischen denen ein drittes elektrisches Feld (E3) aufbaubar ist.

## Beschreibung

Die vorliegende Erfindung bezieht sich auf eine Sensoreinrichtung, die insbesondere zum Erfassen von Objekten dient. Dabei handelt es sich bei der Sensoreinrichtung insbesondere um eine kapazitive Sensoreinrichtung.

Kapazitive Sensoren werden auf vielfältige Art zur Erkennung von Objekten und insbesondere dielektrischen und leitfähigen Objekten im Nahbereich eines elektrischen Feldes genutzt. Insbesondere zur Erkennung von Personen und Lebewesen eignet sich das kapazitive Wirkprinzip gut. Die Objekterkennung kann zur Realisierung von Komfortfunktionen, wie zum Beispiel bei berührungsempfindlichen Bildschirmen oder aber zur Realisierung von Sicherheitsfunktionen, wie zum Beispiel für eine Mensch - Roboter - Kollaboration im Falle von Assistenzsystemen genutzt werden. Weitere typische Anwendungen sind Füllstandsensoren und Näherungsschalter für die Prozesssteuerung.

Eine kapazitive Sensorik ermöglicht berührungslose Sicherheitsfunktionen, die einen sicheren Zustand einleiten, noch bevor es zu einer Krafteinwirkung auf Dritte im Gefahrenbereich kommt. Hierfür müssen die Sensoren eine hinreichend große Detektionsreichweite aufweisen, um Reaktions- und Verzögerungszeiten Rechnung tragen zu können.

Um Objekte sicher zu detektieren, eignen sich kapazitive Sensoriken, die nach dem Prinzip der projizierten wechselseitigen Kapazität (engl. mutual capacitance) arbeiten und Elektrodenpaare aufweisen, bei denen eine Elektrode ein veränderliches elektrisches Feld aufspannt und an einer zweiten Elektrode innerhalb des Feldes der in ihr induzierte Verschiebungsstrom gemessen wird.

Schwierigkeiten bereiten derartige kapazitive Sensoreinrichtungen, wenn Objekte in einem Fernbereich unabhängig von dessen Kopplung an das Umgebungspotential erfasst werden sollen. Der Erfindung liegt daher die Aufgabe zugrunde, eine Sensoranordnung aufzuzeigen, welche auch eine Berücksichtigung dieser Effekte ermöglicht.

Diese Aufgabe wird erfindungsgemäß durch den Gegenstand der unabhängigen Ansprüche erreicht.

Vorteilhafte Ausführungsformen und Weiterbildungen sind Gegenstand der Unteransprüche.

Eine erfindungsgemäße Sensoranordnung zum Erfassen von Objekten und insbesondere zum Erfassen einer Position und/oder Gestalt von Objekten weist eine erste kapazitive Sensoreinrichtung auf, welche eine erste Elektrode sowie eine zweite Elektrode aufweist, zwischen denen ein erstes elektrisches Feld aufbaubar ist. Weiterhin weist die Sensoranordnung eine zweite kapazitive Sensoreinrichtung auf, welche ebenfalls eine erste und eine zweite Elektrode aufweist, zwischen denen ein zweites elektrisches Feld aufbaubar ist.

Erfindungsgemäß weist die Sensoranordnung eine dritte kapazitive Sensoreinrichtung auf, welche eine erste Elektrode und eine zweite Elektrode aufweist, zwischen denen ein drittes elektrisches Feld aufbaubar ist.

Es wird daher vorgeschlagen, dass die Sensoranordnung bzw. das Sensorsystem wenigstens drei kapazitive Sensoren aufweist. Unter einem Erfassen von Objekten wird insbesondere ein Erfassen einer Position der Objekte und/oder eine Erfassung einer Oberflächengestalt der Objekte verstanden. Daneben können jedoch auch andere Daten erfasst werden wie etwa eine Bewegungsgeschwindigkeit des Objekts, eine Beschleunigung des Objekts oder dergleichen.

Bevorzugt sind diese drei Sensoreinrichtungen räumlich diversitär und/oder verteilt angeordnet. Weiterhin weisen die Sensoreinrichtungen bevorzugt eine hohe Fernbereichsempfindlichkeit auf, welche eine Erkennung von Menschen in einem Abstand von einem Meter oder mehr ermöglicht.

Bevorzugt gibt die erste Sensoreinrichtung ein erstes Messsignal aus, die zweite Sensoreinrichtung gibt ein zweites Messsignal aus und die dritte Sensoreinrichtung gibt ein drittes Messsignal aus.

Dabei können diese Messsignale jeweils charakteristisch für ein Objekt sein, das sich in einem Bereich der jeweiligen Sensoreinrichtungen befindet. Weiterhin weist bevorzugt die Sensoreinrichtung eine Auswerteeinrichtung auf, welche die Messsignale auswertet und bevorzugt wenigstens einen Wert ausgibt, der für ein in einem Feldbereich wenigstens einer der Sensoreinrichtungen befindliches Objekt charakteristisch ist.

Bei einer weiteren bevorzugten Ausführungsform weist die Sensoranordnung wenigstens eine weitere Sensoreinrichtung und bevorzugt eine Vielzahl weiterer Sensoreinrichtungen auf. Vorteilhaft weist die Sensoreinrichtung wenigstens zwei weitere Sensoreinrichtungen, bevorzugt wenigstens drei weitere Sensoreinrichtungen und bevorzugt wenigstens vier weitere Sensoreinrichtungen auf.

Bevorzugt handelt es sich auch bei diesen weiteren Sensoreinrichtungen um kapazitive Sensoreinrichtungen. Es wäre jedoch auch möglich, dass lediglich einige dieser weiteren Sensoreinrichtungen kapazitive Sensoreinrichtungen sind.

Bei einer weiteren bevorzugten Ausführungsform ist die Anzahl der verwendeten Sensoreinrichtungen größer als 5, bevorzugt größer als 7, bevorzugt größer als 8, bevorzugt größer als 9 und besonders bevorzugt größer als 10. Durch die Verwendung einer größeren Anzahl an Sensoreinrichtungen kann die Genauigkeit der Sensoreinrichtung in ihrer Gesamtheit verbessert werden.

Bevorzugt wertet die Auswerteeinrichtung die Messsignale sämtlicher Sensoreinrichtungen aus. Weiterhin ist bevorzugt eine Prozessoreinrichtung vorgesehen, welche auf Basis dieser Messsignale oder der sich hieraus durch die Auswerteeinrichtung ergebenden Messwerte einen Ort und/oder eine Gestalt eines Objekts bestimmt.

Bevorzugt ist eine Prozessoreinrichtung vorgesehen, welche anhand der Signale der einzelnen Sensoreinrichtungen eine Ortsbestimmung eines in der Umgebung der Sensoranordnung befindlichen Objekts ermöglicht.

Im Rahmen der vorliegenden Anmeldung wird daher mit dem Begriff Sensoranordnung die gesamte Anordnung aus mehreren Sensoren bezeichnet und mit dem Begriff Sensoreinrichtung die einzelne Sensoreinrichtung, welche Bestandteil der Sensoranordnung ist.

Bei einer bevorzugten Ausführungsform weist wenigstens eine dieser Sensoreinrichtungen eine Elektrode auf, sowie eine Signalerzeugungseinrichtung, welche diese erste Elektrode mit einem elektrischen Signal beaufschlagt, wodurch die erste Elektrode ein elektrisches Feld ausgibt. Weiterhin weist diese Sensoreinrichtung eine zweite Elektrode auf, die von der ersten Elektrode beabstandet ist und die zur Aufnahme des von der ersten Elektrode ausgegebenen elektrischen Feldes dient.

Weiterhin weist die Sensoreinrichtung eine dritte Elektrode auf sowie auch eine Signalerzeugungseinrichtung, welche diese dritte Elektrode mit einem zweiten elektrischen Signal beaufschlagt, wodurch die dritte Elektrode ein weiteres elektrisches Feld ausgibt.

Es wird daher bei dieser vorteilhaften Ausgestaltung die Verwendung einer dritten Elektrode, insbesondere zur Nahbereichserkennung vorgeschlagen. Daneben kann diese dritte Elektrode auch eingesetzt werden, um Effekte von Fremdkörpern wie etwa Flüssigkeiten auf der Sensoreinrichtung zu berücksichtigen.

Vorteilhaft sind mehrere der Sensoreinrichtungen der Sensoranordnung und bevorzugt alle Sensoreinrichtungen der Sensoranordnung in der oben gezeigten Weise ausgestaltet.

Bevorzugt handelt es sich bei der ersten Elektrode um eine Sendeelektrode. Bevorzugt handelt es sich bei der zweiten Elektrode um eine Messelektrode. Weiterhin handelt es sich bevorzugt bei der dritten Elektrode um eine weitere Sendeelektrode.

Bei einer weiteren bevorzugten Ausführungsform handelt es sich bei der Sensoreinrichtung um eine kapazitive Sensoreinrichtung. Bevorzugt sind daher die Elektroden derart angeordnet, dass sich zwischen diesen ein elektrisches Feld nicht durch die kürzeste geometrische Strecke zwischen den Elektroden ergibt, sondern das elektrische Feld gewissermaßen umgelenkt wird.

Bevorzugt liegen eine Fläche der ersten Elektrode und eine Fläche der zweiten Elektrode in einer gemeinsamen Ebene, sind jedoch seitlich versetzt zueinander. Auch eine Elektrodenfläche der dritten Elektrode kann in dieser Ebene liegen. Es wäre auch möglich, dass die Elektrodenoberflächen zueinander versetzt sind, allerdings ist auch hier bevorzugt sichergestellt, dass die Elektrodenoberflächen nicht aufeinander zuweisen, wie dies beispielsweise bei einem Kondensator der Fall wäre, sondern nebeneinander angeordnet sind.

Es wird daher im Rahmen der Erfindung ein kapazitiver Drei- oder Mehrelektrodensensor beschrieben, der auch zur sicheren Fernbereichsdetektion verwendet werden kann. Dabei wird eine Lösung aufgezeigt, wie ein Objekt im Fernbereich unabhängig von dessen Kopplung an ein Umgebungsfeld durch kapazitive Kopplung an eine dem Sensor zugehörige dritte Elektrode, insbesondere mit einem Bezugspotential, sicher erkannt werden kann.

Allerdings ist auch ein derartiger Drei-Elektroden-Sensor für sich allein noch nicht in der Lage, die Größe oder genaue Entfernung eines Objekts zu schätzen, sodass bei einer sicheren Auslegung einer entsprechenden Näherungssensorik der ungünstigste Fall angenommen werden muss, insbesondere ein Fall, bei dem das zu detektierende Objekt eine minimal anzunehmende Größe und Leitfähigkeit oder Dielektrizität aufweist, wobei bevorzugt auch das zu detektierende Objekt hier von der Umgebung kapazitiv und ohmsch-entkoppelt ist (bzw. dies angenommen wird).

In der Realität sind die zu detektierenden Objekte unterschiedlich groß und mehr oder weniger stark ohmsch und/oder kapazitiv an die Umgebung gekoppelt. Dies führt dazu, dass insbesondere große Objekte und gut an die Umgebung gekoppelte Objekte in größerer Entfernung erkannt werden, als gewünscht und falsch positive Auslösungen auftreten, die die Robustheit des Systems beeinträchtigen. Diesem Effekt kann durch das Herabsetzen der Sensitivität der Sensorik entgegengewirkt werden, wodurch die minimale Erkennungsreichweite sinkt.

Die Problematik der Abhängigkeit einer Objekterkennung von der Kopplung des Objekts zu dem Bezugspotential wird im Stand der Technik in unterschiedlicher Weise gelöst. So wird beispielsweise in der US 7 895 014 B1 ein kapazitiver Sensor zur Lokalisierung und Abstandsbestimmung von Zielen mittels Kombination von Signalen von einer Vielzahl an Elektroden beschrieben. Daneben ist es auch bekannt, ein bildgebendes Verfahren der kapazitiven Tomographie (engl. electrical capacitance tomography - kurz: ECT) zu verwenden, das sich besonders für die Darstellung von Flüssigkeiten innerhalb von Rohren eignet.

Die Erfindung ermöglicht eine sichere Lokalisierung von dielektrischen und insbesondere von leitfähigen Objekten im Fernbereich eines kapazitiven Sensorsystems, wobei dies insbesondere weitestgehend unabhängig von der Umgebungs- und Objektbeschaffenheit, beispielswiese einer Objektgröße, und der kapazitiven oder ohmschen Kopplung des zu detektierenden Objekts an die Umgebung, ist.

Dies wird erreicht durch die Verwendung eines kapazitiven Sensorsystems, welches mehrere mit Raumdiversität, d. h. in unterschiedlichen Ebenen, an unterschiedlichen Positionen und/oder mit unterschiedlicher Orientierung bzw. Wirkrichtung angeordnete Sensoren aufweist, deren Messwerte bevorzugt einer zentralen Auswertung zugeführt werden und bevorzugt durch eine geeignete Kombination und Verarbeitung eine Schätzung des zum Objekt eingenommenen Aufenthalts ermöglichen.

Bei einer bevorzugten Ausführungsform der oben beschriebenen Sensoreinrichtung ist die erste und/oder zweite Elektrode, insbesondere die zweite Elektrode, dazu geeignet und bestimmt, das von der dritten Elektrode ausgegebene elektrische Feld aufzunehmen.

Bei einer weiteren vorteilhaften Ausführungsform ist die dritte Elektrode beabstandet von der ersten Elektrode und der zweiten Elektrode angeordnet. Durch diese Beabstandung kann auch eine Fernfelderkennung verbessert werden. Bevorzugt sind auch die erste Elektrode und die zweite Elektrode beabstandet zueinander angeordnet.

Bei einer weiteren bevorzugten Ausführungsform weist die Vorrichtung bzw. die Sensoreinrichtung eine Steuerungseinrichtung auf, welche bewirkt, dass zu den ersten vorgegebenen Zeiträumen die erste Elektrode mit dem ersten Signal beaufschlagt wird und den zweiten vorgegebenen Zeiträumen die dritte Elektrode mit dem zweiten Signal beaufschlagt wird.

Dabei ist es auch möglich, dass die beiden Signale miteinander übereinstimmen. Bevorzugt sind die Zeiträume voneinander getrennt und besonders bevorzugt vollständig voneinander getrennt. Besonders bevorzugt werden die beiden Elektroden nicht gleichzeitig mit einem Signal beaufschlagt. Bevorzugt erfolgt das Beaufschlagen der Elektroden im Wechsel und/oder zyklisch. Es wäre jedoch, insbesondere zur Abschätzung der Position und/oder Gestalt des Objekts auch möglich, die Elektroden gleichzeitig mit dem jeweiligen Signal zu beaufschlagen.

Das hier beschriebene Sensorsystem bzw. die Sensoreinrichtung eignet sich somit zur sicheren Annährungserkennung von Personen und Objekten, insbesondere bei allen Arten von Maschinen, Fortbewegungs- und Beförderungsmitteln, Schließ- und Trennvorrichtungen, Überwachungseinrichtungen und computergesteuerten Systemen, von denen Gefahren ausgehen, die bevorzugt durch die sensorisch unterstützte Sicherheitsfunktion gemindert werden können.

So ermöglicht die Erfindung insbesondere die Erkennung des Umfeldes von Fahrzeugen aller Art (z. B. PKW, LKW, Motorräder, Fahrräder, Schienenfahrzeuge, Kettenfahrzeuge, mobile Roboter und dergleichen), insbesondere bei niedrigen (Relativ-) Geschwindigkeiten (wie diese beispielsweise beim Parken oder Rangieren oder auch beim Kolonnenfahren auftreten können). Auf diese Weise kann ein Schutz von Personen und Lebewesen mittels kapazitiver Sensorik erreicht werden.

Die hier beschriebene Sensoreinrichtung weist daher mindestens drei kapazitive Sensoren auf, die mit Raumdiversität angeordnet sind und bevorzugt eine hohe Fernbereichsempfindlichkeit aufweisen. Dabei sind insbesondere solche Sensoreinrichtungen geeignet, die nach dem Prinzip des Dreielektrodensensors aufgebaut sind, wie oben beschrieben.

Die Messwerte aller Sensoren werden bevorzugt einer zentralen Auswertung zugeführt. Bevorzugt weist die Sensoreinrichtung daher eine Auswerteeinheit auf, welche die von von den einzelnen Sensoreinrichtungen ausgegebenen Signale auswertet. Dabei kann es sich sowohl um diejenigen Signale bzw. Werte handeln, die zu den von der ersten Elektrode ausgegebenen Feldern korrespondieren als auch denjenigen, die zu den von der dritten Elektrode ausgegebenen Feldern korrespondieren.

Bevorzugt ist eine Prozessoreinrichtung vorgesehen, welche anhand der Signale eine Ortsbestimmung eines in der Umgebung der Sensoreinrichtung befindlichen Objekts ermöglicht. Bevorzugt weist daher die Sensoreinrichtung eine Prozessoreinrichtung auf, welche anhand der Signale eine Ortsbestimmung eines in der Umgebung der Sensoreinrichtung befindlichen Objekts ermöglicht.

Die vorliegende Erfindung ist weiterhin auf eine Vorrichtung zum Erkennen von Objekten und insbesondere bewegten Objekten gerichtet, welche eine Sensoranordnung der oben bezeichneten Art aufweist.

Bei einer weiteren bevorzugten Ausführungsform weist die Vorrichtung eine Halteeinrichtung auf, um die Sensoreinrichtung an einem Objekt, wie insbesondere einer Maschine, einem Fahrzeug usw. anzuordnen.

Die vorliegende Erfindung ist weiterhin auf ein Verfahren zum Betreiben einer kapazitiven Sensoranordnung zur Objekterkennung gerichtet, wobei von einer ersten kapazitiven Sensoreinrichtung ein erstes elektrisches Feld ausgegeben wird, von einer zweiten kapazitiven Sensoreinrichtung ein zweites elektrisches Feld ausgegeben wird und von einer dritten kapazitiven Sensoreinrichtung ein drittes elektrisches Feld ausgegeben wird und die erste Sensoreinrichtung ein erstes Messsignal ausgibt, die zweite Sensoreinrichtung ein zweites Messsignal ausgibt und die dritte Sensoreinrichtung ein drittes Messsignal ausgibt, wobei mittels einer Auswerteeinrichtung die Messsignale ausgewertet werden, um wenigstens einen Messwert auszugeben, der für den Ort und/oder die Gestalt eines Objekts charakteristisch ist.

Bei einem bevorzugten Verfahren wird die Sensoranordnung unter Verwendung eines ortsveränderlichen Referenzobjekts kalibriert. Dabei kann eine Winkelschätzung oder eine Positionsschätzung des jeweiligen Objekts vorgenommen werden.

Bevorzugt kommt ein Verfahren zum Betreiben einer kapazitiven Sensoreinrichtung zur Anwendung, wobei von einer Signalerzeugungseinrichtung eine erste Elektrode mit einem elektrischen Signal beaufschlagt wird, wodurch die erste Elektrode ein elektrisches Feld ausgibt, und wobei mit einer zweiten Elektrode, welche von der ersten Elektrode beabstandet ist, das von der ersten Elektrode ausgegebene elektrische Feld aufgenommen wird.

Vorteilhaft ist eine dritte Elektrode vorgesehen, sowie eine Signalerzeugungseinrichtung, welche diese dritte Elektrode mit einem zweiten elektrischen Signal beaufschlagt, wodurch die dritte Elektrode ein weiteres elektrisches Feld ausgibt. Bevorzugt wird auch dieses von der dritten Elektrode ausgegebene elektrische Feld von einer weiteren Elektrode und insbesondere der zweiten Elektrode aufgenommen.

Bei einem bevorzugten Verfahren wird die Sensoreinrichtung unter Verwendung eines ortsveränderlichen Referenzobjekts kalibriert. Dabei können insbesondere Referenzdaten bzw.

Referenzwerte aufgenommen und insbesondere abgespeichert werden, die bei der (insb. späteren) Anwendung des Verfahrens als Vergleichswerte dienen.

Bei einem weiteren bevorzugten Verfahren kann mittels einer Auswerteeinrichtung ein Messwert ermittelt werden, der von dem von der ersten Elektrode ausgegebenen und von der zweiten Elektrode aufgenommenen elektrischen Feld abhängt und weiterhin ein zweiter Messwert, der von dem von der dritten Elektrode ausgegebenen und von der zweiten Elektrode aufgenommenen elektrischen Feld abhängt und auf Basis dieser Messwerte wird bevorzugt eine Aufenthaltsbestimmung eines sich in der Nähe der Sensoreinrichtung befindlichen Objekts vorgenommen.

Dabei kann, wie unten genauer beschrieben, eine Winkelschätzung und/oder eine Positionsschätzung vorgenommen werden.

Im Rahmen einer Auswertung der von allen Sensoreinrichtung ausgegebenen Werten und/oder Signalen und insbesondere mittels einer zentralen Auswerteeinrichtung können logische Tupel aus einem oder mehreren Sensoreinrichtungen (bzw. den von diesen ausgegebenen Signalen bzw. Werten) gebildet werden. Zu jedem Tupel kann eine Schätzung eines Aufenthaltsbereichs durchgeführt werden, wobei, wie oben erwähnt, wahlweise eine Winkelschätzung oder eine Positionsschätzung erfolgt. Hierzu können Algorithmen eingesetzt werden. Je nach Algorithmus kann eine winkelbezogene Wahrscheinlichkeitsverteilung oder auch eine positionsbezogene Wahrscheinlichkeitsverteilung ermittelt bzw. rückgeliefert werden.

In einem weiteren Verfahrensschritt können diese Schätzungen zu allen Tupeln überlagert werden, sodass sich eine Wahrscheinlichkeitsverteilung für den von dem Objekt eingenommenen und/oder verdeckten Bereich ergibt. Auf Basis dieser Wahrscheinlichkeitsverteilung kann mittels mathematischer Verfahren wie z.B. einer Cluster-Analyse eine Schätzung der Objektfront in Richtung eines Sensorsystems mit hoher Genauigkeit erfolgen.
So kann beispielsweise ein Algorithmus für ein definiertes Sensortupel anhand von Messwertabweichungen von jedem Sensor gegenüber einem einkalibrierten Referenzwert und anhand der Positionen der Sensoreinrichtungen mehrere dreidimensionale Richtungsvektoren, ausgehend z. B. vom Mittelpunkt eines Sensortupels ausgeben.

Den einzelnen Richtungsvektoren sind bzw. werden Wahrscheinlichkeiten zugeordnet. Durch das Schneiden der Richtungsvektoren von mehreren oder allen Tupeln ergeben sich Schnittpunkte, denen wiederum Wahrscheinlichkeiten zugeordnet werden.

Durch das Verbinden der Schnittpunkte mit den höchsten Wahrscheinlichkeiten ergibt sich der geschätzte Aufenthaltsbereich des Objekts oder einer Objektfront. Dies wird untenstehend unter Bezugnahme auf die Figuren genauer erläutert.

Damit werden bevorzugt ein oder mehrere Referenzpunkte festgelegt, von denen aus mittels derer die Richtung, in der sich das Objekt befindet, ermittelt werden kann. Bevorzugt ist eine Vergleichseinrichtung vorgesehen, welche aufgenommene Messwerte mit einem oder mehreren Referenzwerten vergleicht. Diese Referenzwerte können dabei durch die oben beschriebene Kalibrierung aufgenommen werden.

Auch werden bevorzugt dreidimensionale Richtungsvektoren von der vorgegebenen Position, beispielsweise ausgehend von dem Mittelpunkt eines Sensortupels bestimmt.

Bevorzugt werden diesen Richtungsvektoren Wahrscheinlichkeiten zugeordnet.

Dieses hier beschriebene Verfahren weist bestimmte Ähnlichkeiten von bildgebenden Verfahren der Tomografie auf, erlaubt aber im Gegensatz zu einem solchen Verfahren nicht das vollständige "Durchleuchten" des Objekts.

Bei einem weiteren bevorzugten Verfahren kann ein Sensorsystem aus mindestens vier Sensoreinrichtungen zugrunde gelegt werden. Dabei bildet bevorzugt das Sensorsystem vier Tupel zu je einer einzelnen Sensoreinrichtung ab.

Dabei kann für jedes Mittel des Sensortupels bzw. Wertetupels, beispielsweise anhand von Referenzwerttabellen, insbesondere dreidimensionalen Referenzwerttabellen, eine Wahrscheinlichkeitsverteilung für die Position eines Objekts bestimmt werden. Diese Referenzwerttabellen werden bevorzugt durch Kalibration gewonnen, indem zu verschiedenen Positionen eines Objekts im dreidimensionalen Raum jeweils die Messwerttupel aller Sensortupel aufgenommen werden. Im einfachsten Fall können also nur die Messwerte der einzelnen Sensoren aufgenommen werden.

Aus diesen Werten können, wie unten genauer definiert wird, die Bereiche größter Aufenthaltswahrscheinlichkeit eines Objekts für jede Sensoreinrichtung bestimmt werden. Diese Flächen werden auch als Isoflächen bezeichnet, weil an allen Punkten einer Isofläche der gleiche Messwert bzw. das gleiche Messwerttupel als maximal wahrscheinlich angenommen wird.

Bei einer Überlagerung der Wahrscheinlichkeitsverteilungen aller Tupel, was beispielsweise durch arithmetisch gewichtete Mittelung der Wahrscheinlichkeiten erfolgt, ergibt sich ein Raumbereich, in dem das Objekt und/oder die Objektfront mit einer bestimmten Wahrscheinlichkeit geschätzt werden kann.

Dabei kann beispielsweise, wie unten genauer erläutert wird, ein punktförmiges Objekt geschätzt werden. Der Raumbereich höchster Aufenthaltswahrscheinlichkeit kann sich beispielsweise nach Überlagerung durch den Schnittpunkt der Isoflächen ergeben.

Dabei ist es möglich, dass die hier beschriebenen Algorithmen zwei- oder dreidimensional durchgeführt werden. Zur Reduktion eines Rechenaufwands ist auch eine zweidimensionale Ausführung der Algorithmen möglich.

Die maximale Anzahl an Sensoren des Sensorsystems ist begrenzt durch räumliche Gegebenheiten in der Applikation oder auch durch die Rechenleistung der zentralen Auswertung. Eine höhere Anzahl von Sensoren ermöglicht jedoch eine präzisere Schätzung des Objekts bzw. der Objektfront.

Durch die Erfindung kann die Abhängigkeit der Näherungserkennung durch ein kapazitives Sensorsystem von der Umgebungs- und Objektbeschaffenheit reduziert werden, insbesondere von der kapazitiven oder ohmschen Kopplung des Objekts an die Umgebung oder auch durch die räumliche Lokalisierung der Objektfront.

Durch diese Lokalisierung können Strategien für die Einleitung eines sicheren Zustandes implementiert werden, bei denen das Auslöseereignis maßgeblich auf Basis der Entfernung eines Objekts erfolgt. Auf diese Weise kann vermieden werden, dass große oder gut gekoppelte Objekte fälschlich zu einer Auslösung führen oder kleine bzw. schlecht gekoppelte Objekte bei Herabsetzung der Sensitivität nicht mehr detektiert werden.

Damit wird insgesamt eine hohe Robustheit einer Näherungserkennung durch Ausblendung von nicht relevanten Objekten erreicht. Dies bietet einen Funktionsvorteil.

Weiterhin kann eine Objekterkennung unabhängig von der Umgebung erreicht werden und so die Sicherheit erhöht werden.

Daneben kann auch eine hohe Reichweite durch Maximierung der Empfindlichkeit der einzelnen Sensoren und damit ein Funktionsvorteil erreicht werden. Daneben ist auch eine kompakte Bauweise der einzelnen Sensoreinrichtungen sowie auch der Sensoranordnung insgesamt aufgrund der Maximierung der Empfindlichkeit und aufgrund der Synergie durch Zusammenführung der Information mehrerer Sensoren möglich. Auf diese Weise ergibt sich ein Integrations- und ein Kostenvorteil.

Weitere Vorteile und Ausführungsformen ergeben sich aus den beigefügten Zeichnungen.

Darin zeigen:
- Fig. 1: Eine Darstellung zur Veranschaulichung des Messprinzips einer kapazitiven Sensoreinrichtung;
- Fig. 2: ein Beispiel eines Dreielektrodensensors, bei dem die dritte Elektrode an einen Bezugspotential kapazitiv gekoppelt ist;
- Fig. 3: eine Darstellung eines Dreielektrodensensors, bei dem das Objekt über eine dritte Elektrode an einen Bezugspotential kapazitiv gekoppelt ist;
- Fig. 4: eine Sensoranordnung in einer ersten Ausführungsform entsprechend der Erfindung;
- Fig. 5: eine Veranschaulichung zur Lokalisierung eines punktförmigen Objekts mit einem Sensorsystem, welches vier Sensoreinrichtungen aufweist;
- Fig. 6: eine Darstellung zur Ausgestaltung einer Sensoreinrichtung.

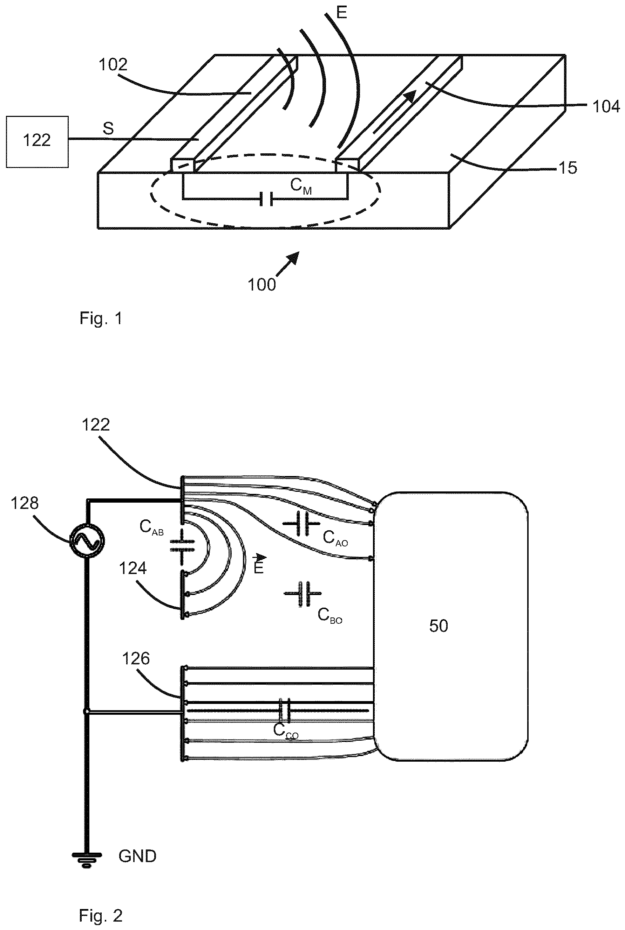

Figur 1 zeigt eine schematische Darstellung einer Sensoreinrichtung 100 nach dem Stand der Technik. Diese Sensoreinrichtung 100 weist eine erste Elektrode 102 auf sowie eine zweite Elektrode 104. Diese Elektroden sind an einem gemeinsamen Träger 15 angeordnet. Das Bezugszeichen 122 kennzeichnet eine Signalerzeugungseinrichtung, welche an die erste Elektrode 102 ein Signal S ausgibt. Dieses Signal erzeugt ein elektrisches Feld E. Dieses elektrische Feld E wird teilweise von der zweiten Elektrode 104 aufgenommen und auf diese Weise ein Verschiebestrom induziert, der entsprechend gemessen werden kann. Dabei wirken sich auf das elektrische Feld auch etwa Objekte aus, welche in einem Bereich zwischen Elektroden 102 oder 104 sind, jedoch auch solche, die in einem entfernten Bereich zwischen den beiden Elektroden 102 und 104 befindlich sind.

Allerdings wirken sich auf die Messung auch Störungen bzw. Objekte aus, wie etwa Wasserfilme, Verschmutzungen oder dergleichen.

Figur 2 veranschaulicht eine Sensoreinrichtung mit drei Elektroden 122, 124 und 126. Dabei wird die erste Elektrode 122 mit einem elektrischen Signal durch eine Signalerzeugungseinrichtung 128 beaufschlagt. Dieses elektrische Feld E wird zwischen dieser ersten Elektrode 122 und der zweiten Elektrode 124 gebildet. Daneben ist eine dritte Elektrode 126 vorgesehen, welche ein Bezugspotential aufweist. Eine genaue Bestimmung der Entfernung eines Objekts ist hier jedoch, wie oben erwähnt nicht möglich, sodass bei einer entsprechenden Näherungssensorik der ungünstigste Fall angenommen werden muss, bei dem das zu detektierende Objekt eine minimal anzunehmende Größe und Leitfähigkeit oder die Elektrizität aufweist und von der Umgebung kapazitiv und ohmsch vollkommen entkoppelt ist, wie in Figur 2 gezeigt.

Hierbei bezeichnen die Bezugszeichen C_{AB}, C_{A0} und C_{B0} jeweils die Kapazitäten einerseits zwischen den Elektroden 122, 124, andererseits zwischen der Elektrode 122 und dem Objekt und auch zwischen der Elektrode 124 und dem Objekt. Das Bezugszeichen C_{CO} kennzeichnet die Kapazität zwischen der Elektrode 126 und dem Objekt 50.

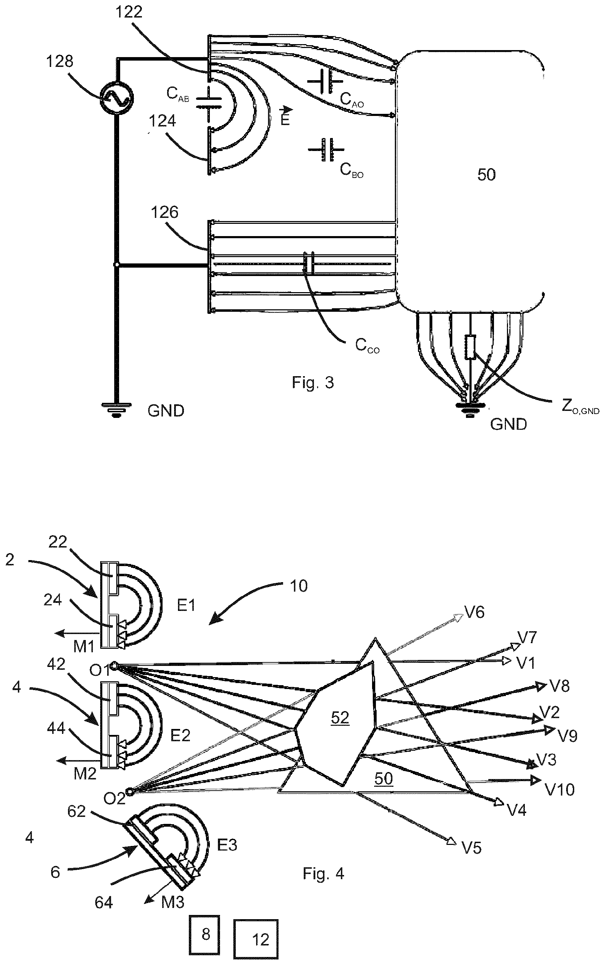

Figur 3 zeigt eine Darstellung einer realen Situation. In der Realität sind die zu detektierenden Objekte unterschiedlich groß und mehr oder weniger stark ohmsch und/oder kapazitiv an die Umgebung gekoppelt, was durch das Bezugszeichen Z_{O,GND} zum Ausdruck gebracht wird. Aus diesem Grunde werden insbesondere Großobjekte und gut an die Umgebung gekoppelte Objekte in größerer Entfernung erkannt als gewünscht und es werden falsch positive Auslösungen auftreten.

Die Erfindung schlägt daher eine Anordnung mit wenigstens drei Sensoreinrichtungen 2, 4, 6 vor, welche auch eine Abschätzung der Größe und genaueren Entfernung eines Objekts 50 ermöglichen.

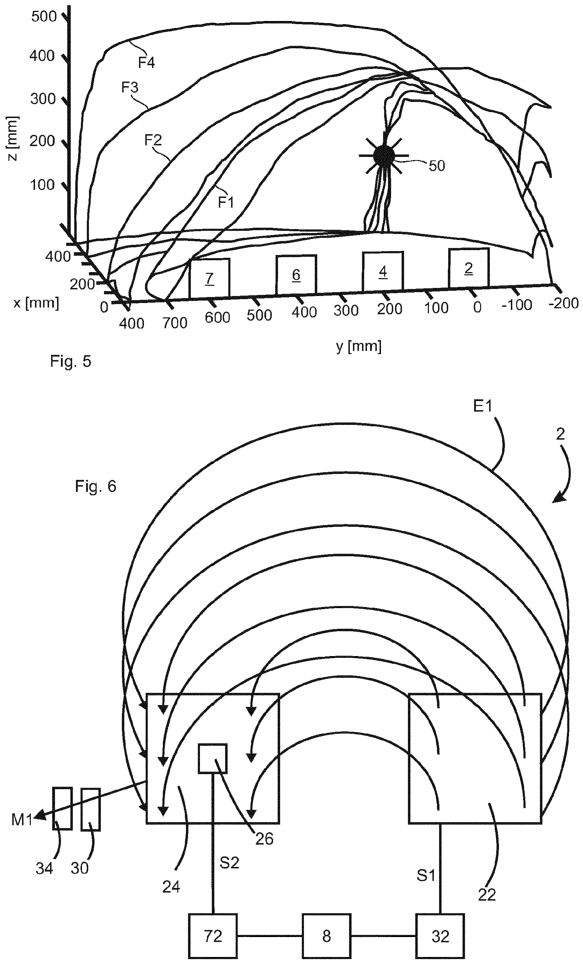

In Figur 4 ist eine Anordnung mit drei Sensoren 2, 4, 6 gezeigt, die hier zur Vereinfachung jeweils zwei Elektroden (22, 24; 42, 44; 62, 64) aufweisen und die mit Raumdiversität und/oder verteilt angeordnet sind. Diese drei Sensoreinrichtungen 2, 4, 6 weisen dabei eine hohe Fernbereichsempfindlichkeit auf. Dabei können insbesondere Sensoreinrichtungen zum Einsatz kommen, welche eine Struktur mit drei Elektroden aufweisen, wie auch in der nachfolgenden Figur 6 gezeigt.

Diese drei Sensoreinrichtungen geben jeweils elektrische Felder E1, E2 und E3 aus. Die Messwerte M1, M2 und M3 aller drei Sensoreinrichtungen werden einer Auswerteeinrichtung 8 zugeführt. Eine Prozessoreinrichtung kann hieraus eine Entfernung und/oder eine Struktur des Objekts 50 erkennen. Die Sensoranordnung 10 wird dabei bevorzugt einmalig oder mehrmalig unter Einfluss eines ortsveränderlichen Referenzobjekts definiert kalibriert. Dabei kann ein Referenzobjekt in unterschiedliche Positionen verbracht werden und jeweils die drei Messwerte M1, M2 und M3 ausgelesen und gespeichert werden. Diese Messwerttupel können dann vorgegebenen Positionen des Referenzobjekts zugeordnet werden und entsprechend in einer Speichereinrichtung abgespeichert werden. Damit hat die zentrale Auswerteeinrichtung Kenntnis über die geometrische Anordnung des Sensorsystems bzw. der Sensoranordnung und die Ergebnisse der Kalibration. Das Bezugszeichen 12 kennzeichnet schematisch eine Prozessoreinrichtung, welche anhand der von der Auswerteeinrichtung 8 ausgegebenen Messwerte eine Abschätzung des Objekts 50 oder dessen Oberfläche 52 ausgibt.

In der Auswerteeinrichtung 8 werden im Arbeitsbetrieb logische Tupel aus einer oder mehreren Sensoreinrichtungen gebildet. Zu jedem Tupel wird eine Schätzung des Aufenthaltsbereichs des Objekts 50 durchgeführt. Dabei kann eine Winkelschätzung mit einem ersten Algorithmus erfolgen. Im Falle des ersten Algorithmus kann eine winkelbezogene Wahrscheinlichkeitsverteilung im Fall des zweiten Algorithmus eine positionsbezogene Wahrscheinlichkeitsverteilung ausgegeben werden.

Konkret zeigt Figur 4 das Konzept einer Lokalisierung für ein Sensorsystem mit drei Sensoreinrichtungen auf Basis des ersten Algorithmus.

Dieser erste Algorithmus ermittelt Werte für jedes definierte Sensortupel, Dies sind in Figur 4 die beiden Tupel anhand deren Messwertabweichungen von jeder Sensoreinrichtung gegenüber einem einkalibrierten Referenzwert ermittelt werden. Anhand der Positionen der Sensoren werden mehrere dreidimensionale Richtungsvektoren V1, V2, V3, V4, V5, V6, V7, V8, V9 und V10, die jeweils von den Mittelpunkten O1 und O2 der beiden Sensortupel bzw. den geometrischen Mittelpunkten zwischen den Sensoreinrichtungen ausgehen, ermittelt. Die Vektoren V1 - V5 sind dabei dem ersten Mittelpunkt O1 zugeordnet und die Vektoren V6 - V10 dem zweiten Mittelpunkt. Es sind jedoch aus Gründen der Übersichtlichkeit in Fig. 4 nur einige der Bezugszeichen der Vektoren eingetragen.

Den einzelnen Richtungsvektoren sind bzw. werden Wahrscheinlichkeiten zugeordnet. Durch das Schneiden der Richtungsvektoren V1 bis V10 mit den höchsten Wahrscheinlichkeiten ergibt sich der geschätzte Aufenthaltsbereich des Objekts oder der Objektfront 52. Dieses Verfahren hat, wie oben erwähnt Ähnlichkeiten mit dem bildgebenden Verfahren der Tomographie.

Die jeweiligen Winkelabschätzungen können aus den Messwertabweichungen der jeweiligen Sensoreinrichtungen (im Falle des Referenzpunkts O1 der Felder E1 und E2) ausgegeben werden.

Figur 5 zeigt die Lokalisierung eines punktförmigen Objekts 50 für ein Sensorsystem, welches vier Sensoreinrichtungen 2, 4, 6 und 7 aufweist, die hier an vorgegebenen Positionen angeordnet sind.

Die Referenzwerttabellen werden durch eine Kalibration gewonnen, indem zu verschiedenen Positionen eines Objekts in einem dreidimensionalen Raum jeweils die Messwerttupel aller Sensortupel aufgenommen werden. Im einfachsten Fall können dies die Messwerte der einzelnen Sensoren sein.

In Figur 5 sind die Bereiche höchster Aufenthaltswahrscheinlichkeit eines Objekts für jeden Sensor als Flächen F1 bis F4 dargestellt. Diese Flächen können auch als Isoflächen bezeichnet werden, weil an allen Punkten einer Isofläche der gleiche Messwert als maximal wahrscheinlich angenommen wird. Bei Überlagerung der Wahrscheinlichkeitsverteilungen aller Tupel, was beispielsweise durch eine arithmetische insbesondere gewichtete Mittelung der Wahrscheinlichkeiten erfolgen kann, ergibt sich ein Raumbereich, in dem das Objekt 50 bzw. dessen Objektfront mit einer bestimmten Wahrscheinlichkeit geschätzt wird. In Figur 5 wird ein punktförmiges Objekt geschätzt, der Raumbereich höchster Aufenthaltswahrscheinlichkeit ergibt sich nach Überlagerung als Schnittpunkt der Isoflächen.

Figur 6 zeigt grob schematisch eine Sensoreinrichtung 2 für eine erfindungsgemäße Sensoranordnung. Auch diese weist wieder eine erste Elektrode 22 auf, sowie eine zweite Elektrode 24. Die erste Elektrode 22 wird dabei über eine Signalerzeugungseinrichtung 32 mit einem Signal S1 beaufschlagt und erzeugt auf diese Weise ein elektrisches Feld E1. Dieses elektrische Feld E1 wird von der zweiten Elektrode 24 aufgenommen, welche einen Verschiebestrom erzeugt, der wiederum mittels einer Messeinrichtung 30 gemessen werden kann.

Entsprechend kann der Verschiebestrom oder ein zu diesem korrespondierendes Signal über eine Auswerteeinrichtung 30 als erstes Messsignal M1 ausgegeben werden. Die Auswerteeinrichtung 30 berechnet daher vorteilhaft aus dem Verschiebestrom das erste Messsignal M1.

Die beiden Elektroden 22 und 24 sind hier plattenförmig ausgebildet und bevorzugt parallel zueinander, sodass sich die elektrischen Feldlinien nicht nur in gerader Richtung zwischen den Elektroden 22, 24 erstrecken, sondern den in Figur 6 gezeigten gekrümmten Verlauf annehmen. Auf diese Weise können auch Objekte im Fernbereich der beiden Elektroden 22, 24 registriert werden, obwohl dieser Fernbereich nicht geometrisch zwischen den Elektroden 22, 24 angeordnet ist bzw. liegt.

Bevorzugt sind die genannten Elektroden auf einem gemeinsamen Träger angeordnet. Weiterhin können auch die Signalerzeugungseinrichtung(en) auf diesem Träger angeordnet sein.

Das Bezugszeichen 26 kennzeichnet eine dritte Elektrode, die hier im Bereich der zweiten Elektrode 24 angeordnet ist. Bei dem in Figur 2 gezeigten Zustand wird diese dritte Elektrode 26 nicht mit einem Signal versorgt. Allerdings ist auch hier eine Signalerzeugungseinrichtung 72 vorgesehen, welche die dritte Elektrode 26 mit einem insbesondere elektrischen Signal beaufschlagen kann.

Das Bezugszeichen 8 kennzeichnet eine Steuerungseinrichtung, welche die Ansteuerung der ersten Elektrode 22 sowie der dritten Elektrode 26 mit einem Signal bewirkt. Diese Steuerungseinrichtung 8 kann dabei diese beiden Signalerzeugungseinrichtungen 32 und 72 beispielsweise zu unterschiedlichen Zeiträumen ansteuern. Es wird jedoch darauf hingewiesen, dass die Steuerungseinrichtung 8 sowie die beiden Signalerzeugungseinrichtungen 32 und 72 auch in einer gemeinsamen Steuerungseinheit untergebracht sein können.

Die Anmelderin behält sich vor, sämtliche in den Anmeldungsunterlagen offenbarten Merkmale als erfindungswesentlich zu beanspruchen, sofern sie einzeln oder in Kombination gegenüber dem Stand der Technik neu sind. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

## Patentansprüche

1. Sensoranordnung (10) zum Erfassen von Objekten (50) mit einer ersten kapazitiven Sensoreinrichtung (2), welche eine erste Elektrode (22) sowie eine zweite Elektrode (24) aufweist, zwischen denen ein erstes elektrisches Feld (E1) aufbaubar ist und mit einer zweiten kapazitiven Sensoreinrichtung (4), welche eine erste Elektrode (42) sowie eine zweite Elektrode (44) aufweist, zwischen denen ein zweites elektrisches Feld (E2) aufbaubar ist,
**dadurch gekennzeichnet, dass**
die Sensoranordnung (10) eine dritte kapazitive Sensoreinrichtung (6) aufweist, welche eine erste Elektrode (62) und eine zweite Elektrode (64) aufweist, zwischen denen ein drittes elektrisches Feld (E3) aufbaubar ist.

2. Sensoranordnung (10) nach Anspruch 1,
**dadurch gekennzeichnet, dass**
die erste Sensoreinrichtung (2) ein erstes Messignal (M1) ausgibt, die zweite Sensoreinrichtung (4) ein zweites Messsignal (M2) ausgibt und die dritte Sensoreinrichtung (6) ein drittes Messignal (M3) ausgibt.

3. Sensoranordnung (10) nach dem vorangegangenen Anspruch,
**dadurch gekennzeichnet, dass**
die Sensoranordnung eine Auswerteeinrichtung (8) aufweist, welche die Messignale (M1, M2, M3) auswertet und wenigstens einen Wert ausgibt, der für ein in einem Feldbereich wenigstens einer der Sensoreinrichtungen befindliches Objekt (50) charakteristisch ist.

4. Sensoranordnung (10) nach wenigstens einem der vorangegangenen Ansprüche,
**dadurch gekennzeichnet, dass**
die Sensoranordnung (10) wenigstens eine weitere Sensoreinrichtung und bevorzugt eine Vielzahl weiterer Sensoreinrichtungen aufweist.

5. Sensoranordnung (10) nach wenigstens einem der vorangegangenen Ansprüche,
**dadurch gekennzeichnet, dass** wenigstens eine Sensoreinrichtung (2) die erste Elektrode (22) aufweist sowie eine Signalerzeugungseinrichtung (32), welche diese erste Elektrode (22) mit einem elektrischen Signal (S1) beaufschlagt, wodurch die erste Elektrode (22) ein elektrisches Feld (E1) ausgibt, sowie eine zweite Elektrode (24), welche von der ersten Elektrode (22) beabstandet ist, zur Aufnahme des von der ersten Elektrode (22) ausgegebenen elektrischen Feldes (E1)
**dadurch gekennzeichnet, dass**
die Sensoreinrichtung (2) eine dritte Elektrode (26) aufweist, sowie eine Signalerzeugungseinrichtung (72), welche diese dritte Elektrode (26) mit einem zweiten elektrischen Signal (S2) beaufschlagt, wodurch die dritte Elektrode (26) ein weiteres elektrisches Feld ausgibt.

6. Sensoranordnung (10) nach dem vorangegangenen Anspruch,
**dadurch gekennzeichnet, dass**
die Sensoreinrichtung (2, 4, 6, 7) eine Steuerungseinrichtung (8) aufweist, welche bewirkt, dass zu ersten vorgegebenen Zeiträumen die erste Elektrode (wenigstens einer Sensoreinrichtung) mit dem ersten Signal (S1) beaufschlagt wird und zu zweiten vorgegebenen Zeiträumen die dritte Elektrode mit dem zweiten Signal (S2) beaufschlagt wird.

7. Sensoranordnung (10) nach wenigstens einem der vorangegangenen Ansprüche,
**dadurch gekennzeichnet, dass**
die Sensoreinrichtung (1) eine Auswerteeinheit aufweist, welche die von der zweiten Elektrode aufgenommenen Signale auswertet.

8. Sensoranordnung (10) nach dem vorangegangenen Anspruch,
**dadurch gekennzeichnet, dass**
eine Prozessoreinrichtung vorgesehen ist, welche anhand der Signale der Sensoreinrichtungen (2, 4, 6, 7) eine Ortsbestimmung eines in einer Umgebung der Sensoreinrichtung befindlichen Objekts (50) ermöglicht.

9. Vorrichtung zum Erkennen von insbesondere bewegten Objekten mit einer Sensoreinrichtung nach wenigstens einem der vorangegangenen Ansprüche.

10. Verfahren zum Betreiben einer kapazitiven Sensoranordnung zur Objekterkennung wobei von einer ersten kapazitiven Sensoreinrichtung (2) ein erstes elektrisches Feld (E1) ausgegeben wird, von einer zweiten kapazitiven Sensoreinrichtung (4) ein zweites elektrisches Feld (E2) ausgegeben wird und von einer dritten kapazitiven Sensoreinrichtung (6) ein drittes elektrisches Feld ausgegeben wird und die erste Sensoreinrichtung (2) ein erstes Messignal (M1) ausgibt, die zweite Sensoreinrichtung (4) ein zweites Messsignal (M2) ausgibt und die dritte Sensoreinrichtung (6) ein drittes Messignal (M3) ausgibt, wobei mittels einer Auswerteeinrichtung die Messsignale (M1, M2, M3) ausgewertet werden um wenigstens einen Messwert auszugeben, der für den Ort und/oder die Gestalt eines Objekts (50) charakteristisch ist.

11. Verfahren nach dem vorangegangenen Anspruch,
**dadurch gekennzeichnet, dass**
die Sensoranordnung (10) unter Verwendung eines ortsveränderlichen Referenzobjekts kalibriert wird.
